# EUROPEAN PATENT SPECIFICATION

(11) **EP 3 030 066 B1**
(45) Date of publication and mention of the grant of the patent: **21.03.2018**
(21) Application number: 14832089.8
(22) Date of filing: 25.03.2014
(51) Int. Cl.: H05K 7/20, F21V 29/00, G02F 1/1333, G02F 1/13357, G09F 9/00

(54) **DISPLAY DEVICE**
ANZEIGEVORRICHTUNG
DISPOSITIF D'AFFICHAGE

(30) Priority: 31.07.2013 JP 2013158601
(43) Date of publication of application: 08.06.2016
(73) Proprietor: Panasonic Intellectual Property Management Co., Ltd., Osaka-shi, Osaka 540-6207 (JP)
(72) Inventor: SEKIGUCHI, Tomohiro, Osaka-shi Osaka 540-6207 (JP); NAKASE, Kiyotaka, Osaka-shi Osaka 540-6207 (JP); FURUKAWA, Takayuki, Osaka-shi Osaka 540-6207 (JP)
(74) Representative: Eisenführ Speiser
(86) International application number: PCT/JP2014/001689
(87) International publication number: WO 2015/015673

(56) References cited:
- WO-A1-2010/021188
- JP-A- 2009 099 316
- US-A1- 2008 285 290
- US-A1- 2010 066 937

## Description

### TECHNICAL FIELD

The present disclosure relates to a display device, and more particularly to a liquid crystal display device provided with an LED (Light Emitting Diode) direct backlight.

### BACKGROUND ART

In recent years, a liquid crystal display device provided with a high-luminance LED direct backlight has been put on the market. This type of a liquid crystal display device includes LEDs arranged throughout a liquid crystal screen at positions immediately below the screen, and supplies power to these LEDs arranged throughout the screen.

For the purpose of raising luminance, the liquid crystal display device needs to supply a larger amount of power to the LEDs. When the power supply to the LEDs increases, the temperature of the LEDs rises. With a rise of the temperature of the LEDs, air heated to a high temperature shifts from a lower area to an upper area due to natural convention. This condition forms a large temperature gradient between a lower portion and an upper portion of the backlight. The temperature gradient thus formed causes luminance nonuniformity and color nonuniformity.

In addition, a driver board of the high-luminance LED direct backlight provided for driving the LEDs consumes a large amount of power. Accordingly, the quantity of heat released from the driver board increases; therefore, the temperature of the driver board rises. As a result, the local temperature of the backlight in an area around the driver board rises, so that a temperature gradient is formed in the backlight.

As a technology for avoiding formation of a temperature gradient within a liquid crystal panel, Unexamined Japanese Patent Publication No. 2005-121897 discloses a constitution in which heated air is discharged from air holes of a duct structure constituted by an auxiliary plate.

In US 2008/0285290 A1 a structure in which an air flow generated by a forced convection does not come into contact with an air flow generated by natural convection, by setting a partition all between forced convection path in which the air flows on the basis of a forced convection generated by a cooling fan and a natural convection path in which the air flows on the basis of a natural convection.

In US 2010/0066937 A1 a slim liquid crystal display unit is disclosed which has a large screen by providing a slim structure capable of sufficiently radiating the heat from a light source.

### SUMMARY OF THE INVENTION

It is an object of the present disclosure to provide a display device which includes a structure capable of reducing a temperature gradient.

A display device according to the present disclosure is defined as in claim 1.

This structure decreases a temperature peak and a temperature gradient of a heat generating component.

### BRIEF DESCRIPTION OF DRAWINGS

FIG. 1 is a perspective view illustrating a disassembled structure of a liquid crystal display device according to a first exemplary embodiment.
FIG. 2A is a rear view of the liquid crystal display device according to the first exemplary embodiment.
FIG. 2B is a cross-sectional view of the liquid crystal display device taken along a line 2-2 in FIG. 2A.
FIG. 2C is a view illustrating heat flow in the cross-sectional in FIG. 2B.
FIG. 3A is a rear view of a conventional liquid crystal display device.
FIG. 3B is a cross-sectional view of the liquid crystal display device taken along a line 3-3 in FIG. 3A.
FIG. 3C is a view illustrating heat flow in the cross-sectional in FIG. 3B.
FIG. 4A is a characteristic diagram showing a temperature gradient of a first frame included in the conventional liquid crystal display device.
FIG. 4B is a characteristic diagram showing a temperature gradient of a first frame included in the liquid crystal display device according to the first exemplary embodiment.
FIG. 5A is a rear view of a liquid crystal display device according to a second exemplary embodiment.
FIG. 5B is a cross-sectional view of the liquid crystal display device taken along a line 5-5 in FIG. 5A.
FIG. 6A is a rear view of a liquid crystal display device according to a third exemplary embodiment.
FIG. 6B is a cross-sectional view of the liquid crystal display device taken along a line 6-6 in FIG. 6A.
FIG. 7A is a rear view of another liquid crystal display device according to the third exemplary embodiment.
FIG. 7B is a cross-sectional view of the liquid crystal display device taken along a line 7-7 in FIG. 7A.

### DESCRIPTION OF EMBODIMENTS

Exemplary embodiments are hereinafter described in detail with reference to the drawings. In the following description, excessively detailed explanation may be omitted. For example, detailed description of well-known matters, or repeated description of substantially identical configurations may be omitted. These omissions are made for avoiding unnecessary redundancy of explanation in the following description, and helping those skilled in the art easily understand the contents of the description.

The accompanying drawings and the following description are presented only for the purpose of helping those skilled in the art fully to understand the present disclosure. It is therefore not intended that the scope of the subject matters as claimed in the claims be limited in any way to the accompanying drawings and the following description.

### FIRST EXEMPLARY EMBODIMENT

A first exemplary embodiment is hereinafter described.

### [1-1. Constitution]

Positions and directions in the following description, such as "front" and "rear" sides, are defined on the basis of a display direction of a liquid crystal display device unless particularly noted otherwise. More specifically, in a liquid crystal display device, a side of a liquid crystal display panel where an image is displayed corresponds to a "front" side, while the opposite side of the liquid crystal display panel corresponds to a "rear side". In addition, directions of "up" and "down" in the following description correspond to directions of "up" and "down" when the liquid crystal display panel is viewed from the front side in a posture of use of the liquid crystal display device.

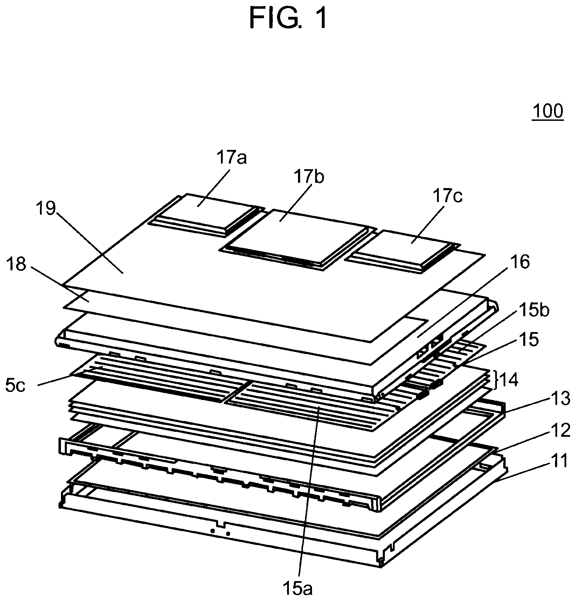

FIG. 1 is a perspective view illustrating a disassembled structure of the liquid crystal display device according to the first exemplary embodiment.

As illustrated in FIG. 1, liquid crystal display device 100 is provided with an LED direct backlight. Liquid crystal display device 100 includes front frame 11, liquid crystal display panel 12 constituted by a 33-inch flat display panel, mold frame 13, optical sheet 14 constituted by a diffusion sheet or a prism sheet, for example, backlight device 15, first frame 16, circuit board 17b containing a plurality of electronic components such as a drive circuit and a memory for displaying images on liquid crystal display panel 12, driver boards 17a and 17c for driving backlight device 15, heat transfer sheet 18, and second frame 19.

Front frame 11 is made of resin, metal, or other materials, and disposed on the front side of liquid crystal display device 100. Front frame 11 surrounds a circumference of liquid crystal display panel 12, and fixes and holds liquid crystal display panel 12.

Mold frame 13 is made of resin, metal, or other materials, and disposed on the rear side of liquid crystal display panel 12. Mold frame 13 fixes and holds liquid crystal display panel 12 and optical sheet 14.

First frame 16 is disposed on the rear side of backlight device 15.

Heat transfer sheet 18 is disposed in an upper portion of the rear side of first frame 16, and positioned as to face a predetermined position of first frame 16, i.e., an area in a range from substantially the center to the upper portion of first frame 16 as viewed in FIG. 1.

Second frame 19 is disposed on the rear side of heat transfer sheet 18, and positioned as to face first frame 16 in a range from a lower portion to the upper portion of first frame 16.

Circuit board 17b and driver boards 17a and 17c are disposed substantially in a lower portion of the rear side of second frame 19.

Liquid crystal display panel 12 includes horizontal and vertical polarizing filters, a glass substrate, and a liquid crystal orientation layer, and is disposed on the front side of backlight device 15. Liquid crystal display panel 12 has an image display area where images are displayed. This liquid crystal display area is disposed on the front side of liquid crystal display panel 12, and exposed to the outside through an opening of front frame 11.

Backlight device 15 is constituted by four backlight units 15a through 15d, and contains LED light sources arranged throughout the area of backlight device 15 both in the length and width directions.

First frame 16 is made of a metal material having high thermal conductivity and high electric conductivity, such as iron and aluminum.

Liquid crystal display panel 12 is held by junction between front frame 11 and mold frame 13 via a junction member. Optical sheet 14 and backlight device 15 are held on first frame 16 by junction between front frame 16 and both backlight device 15 and mold frame 13 via a junction member.

First frame 16 provides functions of both a chassis for holding optical sheet 14 and backlight device 15, and a heat sink constituted by a metal body for radiating heat generated from backlight device 15.

Grooves are formed in an outer circumference of first frame 16. These grooves are portions where wiring and the like are embedded.

A plurality of electronic components such as a driving circuit, a signal processing circuit, and a memory for driving liquid crystal display panel 12 are provided on the rear side of circuit board 17b. On the other hand, a plurality of electronic components such as a driving circuit, a signal processing circuit, and a memory for driving backlight device 15 are provided on the rear side of driver boards 17a and 17c for each.

Heat transfer sheet 18 is made of a heat radiation rubber, for example.

Second frame 19 is made of metal material having high thermal conductivity and high electric conductivity, such as aluminum and copper.

The surfaces of first frame 16 and second frame 19 in the areas facing each other have the same size except for the area of first frame 16 where the grooves are formed.

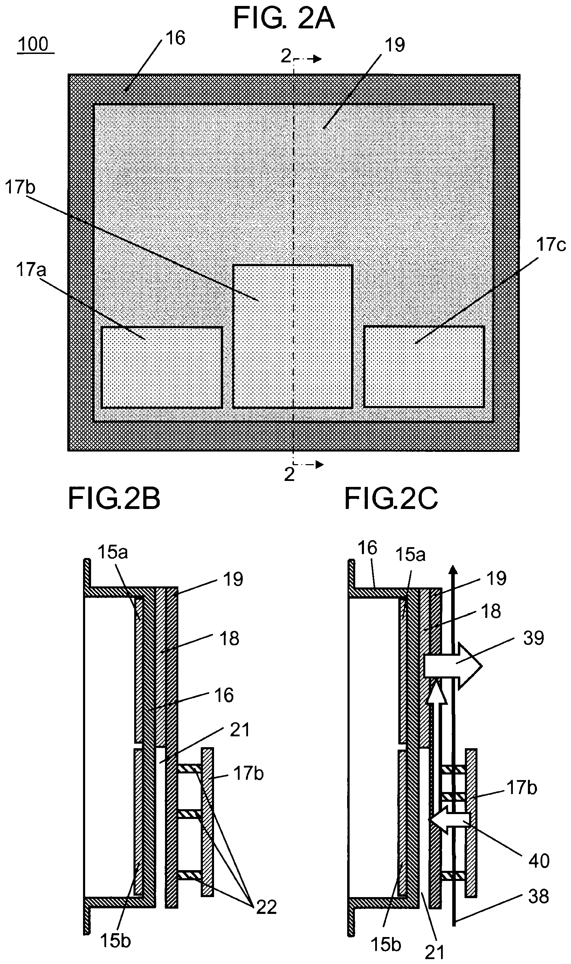

FIG. 2A is a rear view of liquid crystal display device 100. FIG. 2B is a cross-sectional view of liquid crystal display device 100 taken along a line 2-2 in FIG. 2A. This cross-sectional view shows a cross section of liquid crystal display device 100 in a range from the rear side of circuit board 17b to backlight device 15, and does not show a constitution in a range from optical sheet 14 to front frame 11. FIG. 2C illustrates heat flow in the cross section in FIG. 2B.

As illustrated in FIG. 2B, circuit board 17b is held on the rear side of second frame 19 with a constant distance left between circuit board 17b and second frame 19 by the use of a plurality of bosses 22 made of a metal material. Though not shown in the figure, driver boards 17a and 17c are held on the rear side of second frame 19 similarly to circuit board 17b with the same distance as that of circuit board 17b left between driver boards 17a and 17c and second frame 19 by the use of a plurality of bosses.

Heat transfer sheet 18 is disposed between first frame 16 and second frame 19 at a predetermined position, i.e., throughout an area from substantially the center to an upper portion between first frame 16 and second frame 19 according to this exemplary embodiment. A thickness of heat transfer sheet 18, i.e., a distance between first frame 16 and second frame 19 is 0.25 mm. According to this structure, air layer 21 having the same thickness as that of heat transfer sheet 18 is formed throughout an area between first frame 16 and second frame 19, below heat transfer sheet 18. Air layer 21 has a rectangular area having a length from the lowermost end of the plane of first frame 16 to the lowermost end of heat transfer sheet 18 in the vertical direction, and a width from the left end of first frame 16 to the right end of first frame 16 in the horizontal direction, when first frame 16 is viewed from the rear side.

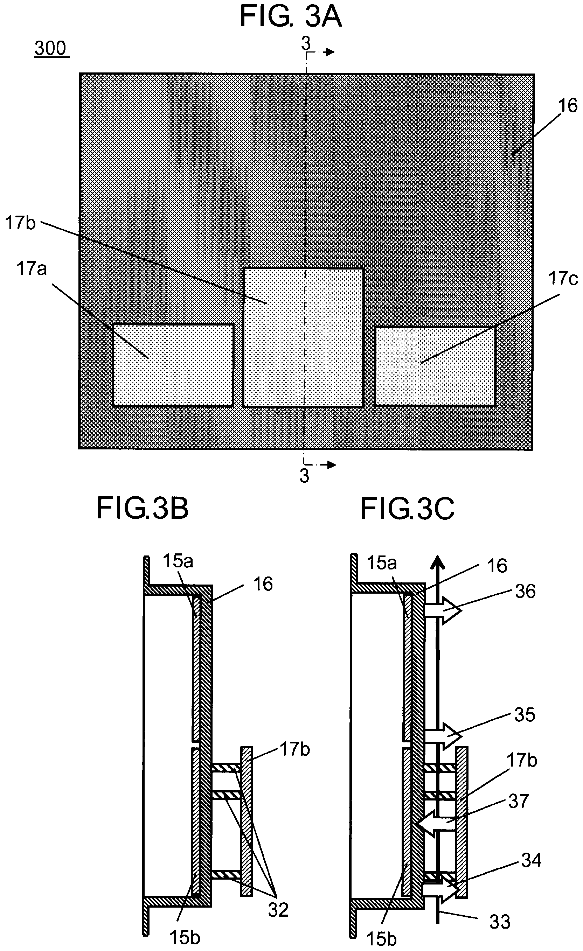

FIG. 3A is a rear view of conventional liquid crystal display device 300. FIG. 3B is a cross-sectional view of liquid crystal display device 300 taken along a line 3-3 in FIG. 3A. Liquid crystal display device 300 does not contain the constitution of heat transfer sheet 18 and second frame 19 in comparison with the structure of liquid crystal display device 100. FIG. 3B does not show the constitution in the range from optical sheet 14 to front frame 11 similarly to FIG. 2B. FIG. 3C illustrates heat flow in the cross section in FIG. 3B.

As illustrated in FIG. 3B, circuit board 17b is held on the rear side of first frame 16 with a constant distance left between circuit board 17b and first frame 16 by the use of a plurality of bosses 32 made of metal material. Though not shown in the figure, driver boards 17a and 17c are held on the rear side of first frame 16 similarly to circuit board 17b with the same distance as that of circuit board 17b left between driver boards 17a and 17c and first frame 16 by the use of a plurality of bosses.

### [1-2. Operation]

Firstly described is a case when conventional liquid crystal display device 300 operates. During operation of liquid crystal display device 300, backlight device 15 does not convert all the supplied power into light, but releases a part of the power as heat. As a result, the entire temperature of liquid crystal display device 300 rises. In addition, the electronic components disposed on circuit board 17b and driver boards 17a and 17c similarly release a part of the supplied power as heat.

First frame 16 is made of a metal material; therefore, heat generated from backlight device 15 is conducted to first frame 16 and raises the temperature of first frame 16. Moreover, the temperature of air on the rear side of first frame 16 rises with the rise of the temperature of first frame 16. With the rise of the temperature of the air, the density of the air decreases, so that upward current 33 is generated. Upward current 33 causes release of the heat of first frame 16 to the entire area on the rear side of first frame 16. The heat flow thus generated is schematically indicated by heat flow 34, 35, and 36. Upward current 33 receives a larger quantity of heat as upward current 33 rises from a lower portion to an upper portion; therefore the temperature difference between upward current 33 and first frame 16 decreases as upward current 33 rises. In this case, the air in the upper portion of first frame 16 provides a smaller cooling effect for first frame 16 than the air in the lower portion of first frame 16. Accordingly, a temperature gradient is formed between the upper portion and the lower portion of first frame 16.

Furthermore, the heat generated from the electronic components disposed on circuit board 17b and driver boards 17a and 17c is conducted to first frame 16 as indicated by heat flow 37, and raises the temperature of first frame 16. In this case, the temperature of first frame 16 locally rises at the positions where the electronic components of circuit board 17b and driver boards 17a and 17b are disposed as viewed from the rear side of first frame 16.

Described next is the case when liquid crystal display device 100 operates. During operation of liquid crystal display device 100, backlight device 15 does not convert all the supplied power into light, but releases a part of the power as heat. As a result, the entire temperature of liquid crystal display device 100 rises. In addition, the electronic components disposed on circuit board 17b and driver boards 17a and 17c similarly release a part of the supplied power as heat.

First frame 16 is made of metal material; therefore, heat generated from backlight device 15 is conducted to first frame 16 and raises the temperature of first frame 16. Moreover, the temperature of air on the rear side of first frame 16 rises with the rise of the temperature of first frame 16. With the rise of the temperature of the air, the density of the air decreases, so that upward current 38 is generated. Upward current 38 causes release of the heat of first frame 16 to the entire area on the rear side of first frame 16.

The heat in the upper portion of first frame 16 is conducted to heat transfer sheet 18 and second frame 19 in this order, and allowed to be released with upward current 38 generated on the rear side of second frame 19 as indicated by heat flow 39.

Air layer 21 has a thickness of 0.25 mm; therefore, air in air layer 21 does not flow even when the temperature of first frame 16 rises. In this case, convective heat transfer does not occur in air layer 21, and heat conductivity of air is sufficiently low; therefore, these conditions provide insulation effectiveness for air layer 21. Accordingly, air layer 21 having this insulation effectiveness insulates heat generated from the lower portion of first frame 16, and prevents release of the heat with upward current 38 generated on the rear side of second frame 19.

In addition, upward current 38 receives a limited quantity of heat from the lower portion of first frame 16, so that the temperature rise of the air during upward rising decreases in comparison with the corresponding temperature rise in the case of conventional liquid crystal display device 300. As a result, the quantity of heat release becomes larger in the upper portion of first frame 16.

In this case, the temperature rise of the lower portion of first frame 16 increases, while the temperature rise of the upper portion of first frame 16 decreases. Accordingly, the temperature gradient in the plane of first frame 16 of liquid crystal display device 100 becomes smaller.

On the other hand, the heat generated from the electronic components of circuit board 17b and driver boards 17a and 17c is conducted to second frame 19 via heat flow 40 generated by conductive heat transfer. However, this heat is difficult to be conducted to first frame 16 by the function of air layer 21 having insulation effectiveness, and therefore diffuses in the plane of second frame 19. As a result, the local temperature rise of first frame 16 produced by the heat of the electronic components on circuit board 17b and driver boards 17a and 17c decreases, so that the temperature gradient of first frame 16 becomes smaller.

A simulation was carried out by using Heat Designer PAC V8 manufactured by Software Cradle Co., Ltd. for comparison between the temperature gradient of first frame 16 of conventional liquid crystal display device 300 and the temperature gradient of first frame 16 of liquid crystal display device 100 according to this exemplary embodiment. The simulation was carried out under the following conditions. Assumed in the simulation was a 33-inch liquid crystal panel. The quantity of heat released from backlight device 15 was set to 120W. The quantity of heat released from circuit board 17b was set to 5W. The quantity of heat released from driver boards 17a and 17b for each was set to 25W. The heat conductivity of the heat transfer sheet was set to 1 w/(°C·m).

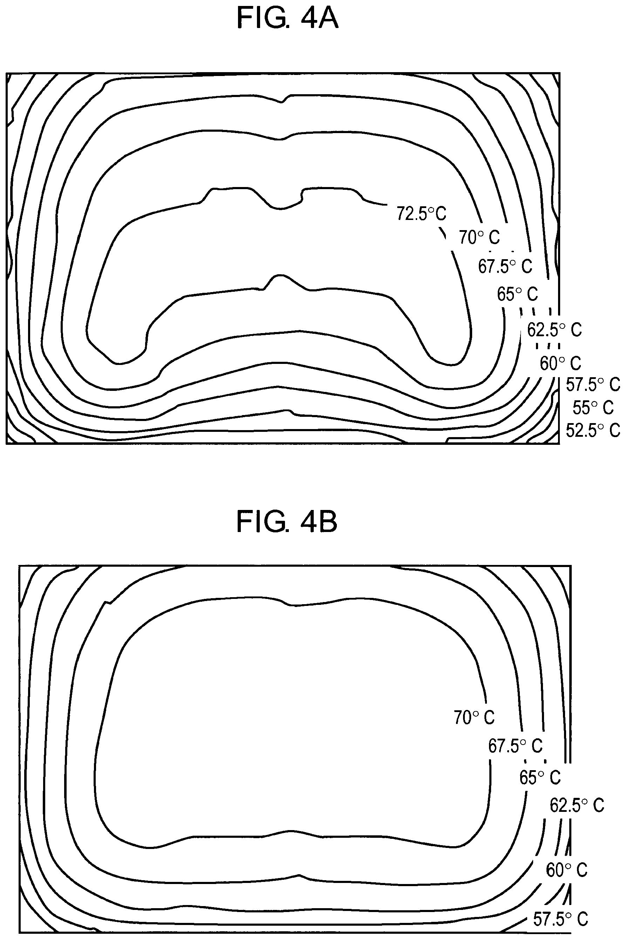

FIG. 4A is a characteristic diagram showing a temperature gradient obtained from the result of the foregoing simulation using first frame 16 of conventional liquid crystal display device 300. FIG. 4B is a characteristic diagram showing a temperature gradient obtained from the result of the foregoing simulation using first frame 16 of liquid crystal display device 100 according to this exemplary embodiment.

As illustrated in FIG. 4A, the temperature of the central portion of first frame 16 was 72.5 °C, while the lower portion of first frame 16 was 52.5 °C. Accordingly, a temperature difference of 20 °C was produced. Particularly, the local temperature of the central portion was higher than the temperature of the other area.

On the other hand, as illustrated in FIG. 4B, the temperature of the central portion of first frame 16 was 70 °C, while the temperature of the lower portion of first frame 16 was 57.5 °C. Accordingly, a temperature difference of 12.5 °C was produced. In addition, the temperature of the central portion of first frame 16 was 2.5 °C lower than the temperature of the corresponding portion of conventional liquid crystal display device 300.

Accordingly, liquid crystal display device 100 in this exemplary embodiment efficiently conducts the heat generated from the upper portion of first frame 16 to heat transfer sheet 18 and second frame 19 and releases the heat, while reducing release of the heat generated from the lower portion of first frame 16 by the function of air layer 21. This structure decreases the temperature peak and the temperature gradient of first frame 16, thereby reducing luminance nonuniformity and color nonuniformity.

Moreover, the heat generated from circuit board 17b and driver boards 17a and 17b provided on second frame 19 is insulated by the function of air layer 21. This structure lowers thermal effect of the heat. In addition, the heat generated from the circuit board 17b and driver boards 17a and 17b is released through the plane of second frame 19. This structure allows easy heat designing.

Next, a simulation was carried out for determining variations of the temperature gradient of liquid crystal display device 100 according to this exemplary embodiment produced by changes of the thickness of heat transfer sheet 18.

The simulation was carried out by using Heat Designer PAC V8 manufactured by Software Cradle Co., Ltd. under the following conditions. Assumed in the simulation was a 33-inch liquid crystal panel. The quantity of heat released from backlight device 15 was set to 120W. The quantity of heat released from circuit board 17b was set to 5W. The quantity of heat released from driver boards 17a and 17b for each was set to 25W. The heat conductivity of the heat transfer sheet was set to 1 w/(°C·m). Table 1 shows simulation results obtained when the thickness of heat transfer sheet 18 was changed in a range from 0 mm to 5 mm.

**[Table 1]**

| THICKNESS OF HEAT TRANSFER SHEET (mm) | TEMPERATURE GRADIENT (°C) | TEMPERATURE GRADIENT DIFFERNCE (°C) | MAXIMUM TEMPERATURE (°C) |
|---|---|---|---|
| 0 | 17 | - | 73.4 |
| 0.01 | 13.4 | 3.6 | 71.8 |
| 0.05 | 12.1 | 4.9 | 71.3 |
| 0.10 | 11.1 | 5.9 | 71.2 |
| 0.25 | 11.1 | 5.9 | 71.4 |
| 0.5 | 11.5 | 5.5 | 71.9 |
| 1.00 | 12.1 | 4.9 | 72.5 |
| 2.00 | 14.6 | 2.4 | 72.8 |
| 5.00 | 16.1 | 0.9 | 72.9 |

The table shows a temperature gradient, a temperature gradient difference, and a maximum temperature of each sheet based on the simulation carried out for measuring the maximum and minimum temperatures for each thickness of heat transfer sheet 18. The temperature gradient difference in this context refers to a difference from a temperature gradient of 17 °C of the structure including a 0-mm-thick air layer, i.e., the structure of conventional liquid crystal display device 300. The results of the simulation show that the temperature gradient difference was 3.6 °C or more from the temperature gradient of conventional liquid crystal display device 300, and that the maximum temperature was maintained at 72.5 °C or lower, i.e., a temperature lower than the maximum temperature of conventional liquid crystal display device 300 by 0.9 °C or more, when the thickness of heat transfer sheet 18 is in a range from 0.01 mm to 1.00 mm.

Particularly, it was found that the temperature gradient difference was 5 °C or more from the temperature gradient of conventional liquid crystal display device 300 when the thickness of heat transfer sheet 18 is in a range from 0.1 mm to 0.5 mm. In addition, the maximum temperature was maintained at approximately 72 °C, which is lower by approximately 1.4 °C than the corresponding temperature of conventional liquid crystal display device 300.

### [1-3. Advantages and Others]

Accordingly, a display device according to this exemplary embodiment includes: a display panel; a plurality of backlight units disposed on the rear side of the display panel; a first frame disposed on the rear side of the plurality of the backlight units; a heat transfer sheet disposed on the rear side of the first frame above a predetermined position; and a second frame disposed on the rear side of the heat transfer sheet. An air layer is formed between the first frame and the second frame, below the heat transfer sheet.

This structure decreases a maximum temperature while decreasing a temperature gradient, thereby reducing luminance nonuniformity and color nonuniformity.

### SECOND EXEMPLARY EMBODIMENT

A second exemplary embodiment is hereinafter described.

### [2-1. Constitution]

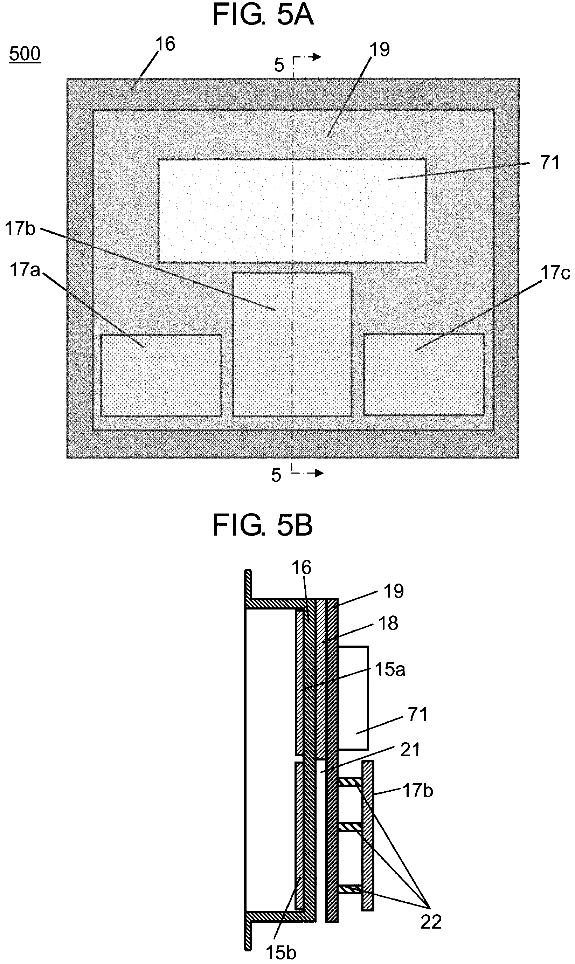

FIG. 5A is a rear view of liquid crystal display device 500 according to the second exemplary embodiment. FIG. 5B is a cross-sectional view taken along a line 5-5 in FIG. 5A. FIG. 5B does not show the constitution from optical sheet 14 to front frame 11 similarly to FIG. 2B. Liquid crystal display device 500 is different from liquid crystal display device 100 according to the first exemplary embodiment in that liquid crystal display device 500 has heat release member 71, such as a heat sink, made of a metal material having high thermal conductivity and high electric conductivity, such as aluminum and copper. Heat release member 71 is disposed on the rear side of second frame 19, and positioned in the area of the upper portion of first frame 16 where the temperature of first frame 16 rises to the maximum.

### [2-2. Operation]

When heat release member 71 is provided in the area of the upper portion of first frame 16 where the temperature rises to the maximum, both the heat release quantity of heat from the upper portion of first frame 16, and the heat release quantity of heat generated from the electronic components on circuit board 17b and driver boards 17a and 17c, conducted to second frame 19 by convective heat transfer, and dispersed in the upper portion of second frame 19 within the plane of second frame 19 increase in comparison with the corresponding heat release quantities of a structure not including heat release member 71.

### [2-3. Advantages and Others]

For the purpose of raising the necessary luminance of liquid crystal display device 500, the power supplied to driver boards 17a and 17c needs to increase. In this case, the quantities of heat released from backlight device 15 and driver boards 17a and 17c become larger. In this case, the temperature difference between the upper portion and the lower portion of first frame 16 is enlarged. According to this exemplary embodiment, however, heat release member 71 reduces the temperature rise of the upper portion, thereby providing excellent temperature gradient reduction effect.

### THIRD EXEMPLARY EMBODIMENT

A third exemplary embodiment is hereinafter described.

### [3-1. Constitution]

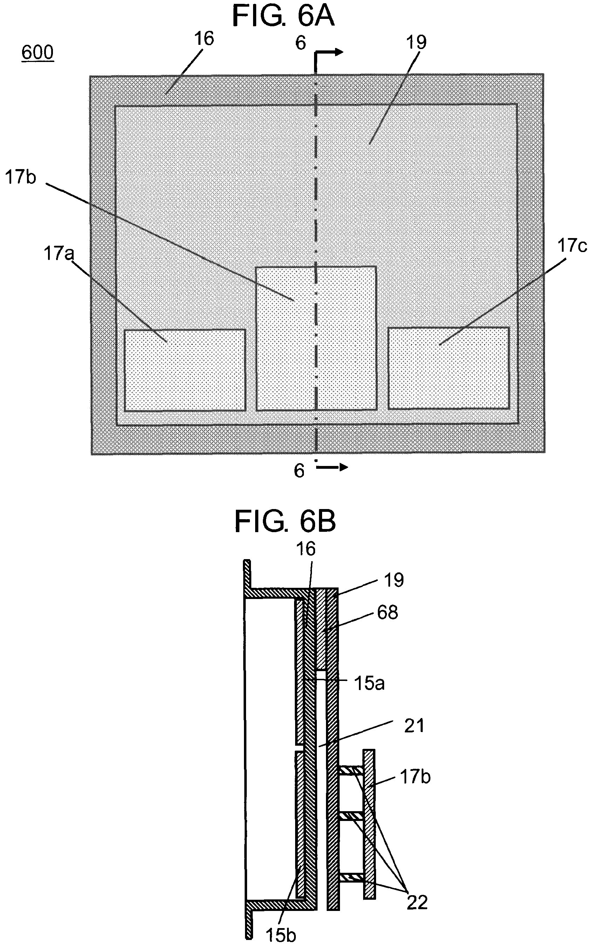

FIG. 6A is a rear view of liquid crystal display device 600 according to the third exemplary embodiment. FIG. 6B is a cross-sectional view taken along a line 6-6 in FIG. 6A. FIG. 6B does not show the constitution from optical sheet 14 to front frame 11 similarly to FIG. 2B.

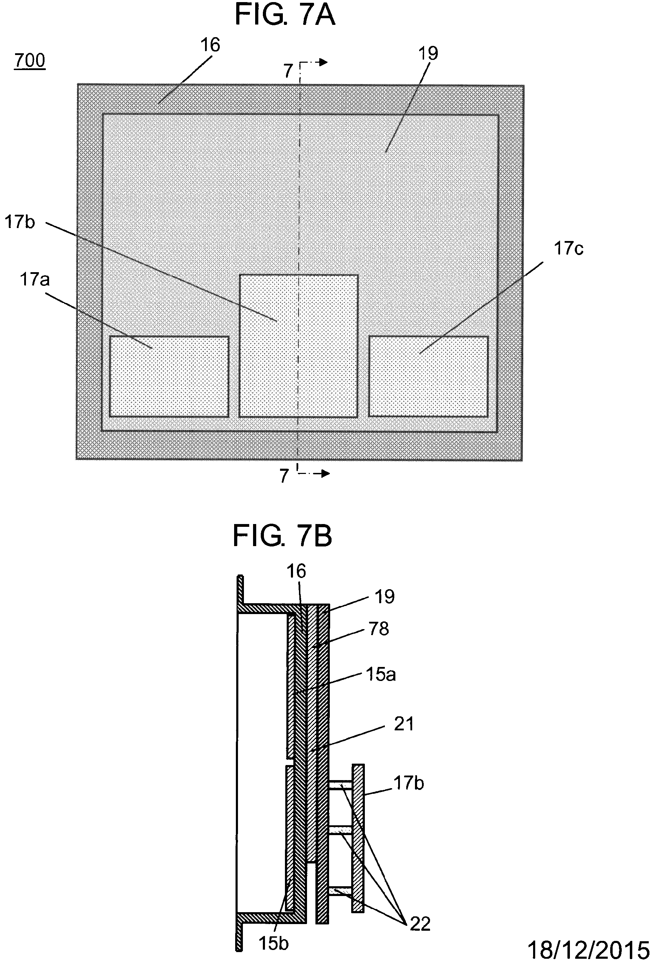

FIG. 7A is a rear view of liquid crystal display device 700 according another example of the third exemplary embodiment. FIG. 7B is a cross-sectional view taken along a line 7-7 in FIG. 7A.

Liquid crystal display device 600 is different from liquid crystal display device 100 according to the first exemplary embodiment in the area covered by heat transfer sheet 68. Heat transfer sheet 68 is smaller than heat transfer sheet 18 in the up-down direction. Heat transfer sheet 68 has approximately one fourth of the area of the rear surface of first frame 16. Liquid crystal display device 700 is different from liquid crystal display device 100 according to the first exemplary embodiment in the area covered by heat transfer sheet 78. Heat transfer sheet 78 is larger than heat transfer sheet 18 in the up-down direction. Heat transfer sheet 78 has approximately three fourths of the area of the rear surface of first frame 16.

### [3-2. Operation]

When the area of heat transfer sheet 68 contracts upward as illustrated in FIG. 6B, the area of air layer 21 increases. This structure upwardly expands the area of air layer 21, thereby upwardly increasing the area for insulating heat generated from first frame 16 by the function of air layer 21 having insulation effectiveness in comparison with the first exemplary embodiment.

When the area of heat transfer sheet 78 expands downward as illustrated in FIG. 7B, the area of air layer 21 decreases. According to this structure, the area for insulating heat generated from first frame 16 by air layer 21 is limited only to a lower area in comparison with the first exemplary embodiment.

### [3-3. Advantages and Others]

In comparison with the first exemplary embodiment, the area of heat transfer sheet 68 or the area of heat transfer sheet 78 according to this exemplary embodiment is contracted or expanded in the up-down direction in accordance with shift of the area of first frame 16 where the temperature within the plane of first frame 16 becomes the maximum in the upward direction in FIG. 6B or downward direction in FIG. 7B. This structure allows adjustment of the heat release quantities from the upper portion and the lower portion of first frame 16. Accordingly, the temperature gradient decreases even when the distribution of the temperature gradient of first frame 16 varies.

According to the first through third exemplary embodiments, backlight device 15 is constituted by LED light sources. However, the backlight may be other types of light sources such as organic light-emitting diodes (OLEDs) and a fluorescent tube. In addition, backlight device 15 is not limited to a direct type as in the exemplary embodiments, but may be an edge light type or other types.

### INDUSTRIAL APPLICABILITY

The present disclosure is applicable to a display device, and particularly to a liquid crystal display device provided with a direct type LED.

### REFERENCE MARKS IN THE DRAWINGS

- 11: front frame
- 12: liquid crystal display panel
- 13: mold frame
- 14: optical sheet
- 15: backlight device
- 16: first frame
- 17a, 17c: driver board
- 17b: circuit board
- 18, 68, 78: heat transfer sheet
- 19: second frame
- 21: air layer
- 22, 32: boss
- 33, 38: upward current
- 34, 35, 36, 37, 39, 40: heat flow
- 71: heat release member
- 100, 300, 500, 600, 700: liquid crystal display device

## Claims

1. A display device (100, 300, 500, 600, 700) comprising:
a display panel (12) facing a viewer standing on a ground at the front of the display device (100, 300, 500, 600, 700); wherein the display device is configured for being positioned in a manner that the display panel is arranged in a vertical position, such that from the perspective of the viewer the device comprises an upper part furthest from the ground, and a lower part nearest to the ground;
a plurality of backlight units (15a, 15b, 15c, 15d) disposed on a rear side of the display panel (12):
a first frame (16) made of metal disposed on a rear side of the plurality of the backlight units (15a, 15b, 15c, 15d);
a second frame (19) made of metal disposed on a rear side of the first frame (16)
a heat transfer sheet (18) disposed between the first frame (16) and the second frame (19) forming a direct connection with both the first and the second frame; wherein the heat transfer sheet (18) is positioned at the upper part of the display device;
a board (17a, 17b, 17c) at the back of the second frame (19) including an electronic component, wherein the board (17a, 17,b, 17c) is positioned at the lower part of the display device wherein an air layer (21) is formed between the first frame (16) and the second frame (19) and positioned at the lower part of the display device in the plane of the heat transfer sheet (18) and overlaps with the position of the board (17a, 17b, 17c).

2. The display device (100, 300, 500, 600, 700) according to claim 1, wherein the heat transfer sheet (18) is positioned in the upper half of the display panel (12) and the board (17a, 17,b, 17c) is positioned in the lower half of the display panel (12) with respect to the viewer.

3. The display device (100, 300, 500, 600, 700) according to claim 1, wherein a thickness of the heat transfer sheet (18) ranges from 0.01 mm to 1.00 mm both inclusive.

4. The display device (100, 300, 500, 600, 700) according to claim 1, wherein a thickness of the heat transfer sheet (18) ranges from 0.1 mm to 0.5 mm both inclusive.

5. The display device (100, 300, 500, 600, 700) according to claim 1, wherein a thickness of the air layer (21) ranges from 0.01 mm to 1.00 mm both inclusive.

6. The display device (100, 300, 500, 600, 700) according to claim 1, wherein a thickness of the air layer (21) ranges from 0.1 mm to 0.5 mm both inclusive.

7. The display device (100, 300, 500, 600, 700) according to claim 1, wherein the heat transfer sheet (18) does not overlap with the position of the board (17a, 17b, 17c).

## Patentansprüche

1. Anzeigevorrichtung (100, 300, 500, 600, 700), Folgendes umfassend:
eine Anzeigetafel (12), die einem Betrachter zugewandt ist, der auf einem Boden an der Vorderseite der Anzeigevorrichtung (100, 300, 500, 600, 700) steht;
wobei die Anzeigevorrichtung so konfiguriert ist, dass sie in einer Weise positioniert ist, dass die Anzeigetafel in einer vertikalen Position angeordnet ist, so dass die Vorrichtung aus Sicht des Betrachters einen vom Boden am weitesten entfernten oberen Teil und einen dem Boden am nächsten liegenden unteren Teil aufweist;
eine Vielzahl von Hintergrundbeleuchtungseinheiten (15 a, 15 b, 15 c, 15 d), die an einer Rückseite der Anzeigetafel (12) angeordnet sind;
einen ersten Rahmen (16) aus Metall, der an einer Rückseite der Mehrzahl der Hintergrundbeleuchtungseinheiten (15 a, 15 b, 15 c, 15 d) angeordnet ist;
einen zweiten Rahmen (19) aus Metall, der an einer Rückseite des ersten Rahmens (16) angeordnet ist,
ein Wärmeübertragungsblatt (18), das zwischen dem ersten Rahmen (16) und dem zweiten Rahmen (19) angeordnet ist und eine direkte Verbindung mit dem ersten und dem zweiten Rahmen bildet; wobei das Wärmeübertragungsblatt (18) an dem oberen Teil der Anzeigevorrichtung positioniert ist;
eine Platine (17 a, 17 b, 17 c) an der Rückseite des zweiten Rahmens (19) mit einer elektronischen Komponente, wobei die Platine (17 a, 17 b, 17 c) an dem unteren Teil der Anzeigevorrichtung positioniert ist,
wobei eine Luftschicht (21) zwischen dem ersten Rahmen (16) und dem zweiten Rahmen (19) ausgebildet ist und am unteren Teil der Anzeigevorrichtung in der Ebene des Wärmeübertragungsblatts (18) positioniert ist und sich mit der Position der Platine (17 a, 17 b, 17 c) überlappt.

2. Anzeigevorrichtung (100, 300, 500, 600, 700) nach Anspruch 1, wobei in Bezug auf den Betrachter das Wärmeübertragungsblatt (18) in der oberen Hälfte der Anzeigetafel (12) positioniert ist und die Platine (17 a, 17 b, 17 c) in der unteren Hälfte der Anzeigetafel (12) positioniert ist.

3. Anzeigevorrichtung (100, 300, 500, 600, 700) nach Anspruch 1, wobei eine Dicke des Wärmeübertragungsblatts (18) im Bereich von einschließlich 0,01 mm bis einschließlich 1,00 mm liegt.

4. Anzeigevorrichtung (100, 300, 500, 600, 700) nach Anspruch 1, wobei eine Dicke des Wärmeübertragungsblatts (18) im Bereich von einschließlich 0,1 mm bis einschließlich 0,5 mm liegt.

5. Anzeigevorrichtung (100, 300, 500, 600, 700) nach Anspruch 1, wobei eine Dicke der Luftschicht (21) im Bereich von einschließlich 0,01 mm bis einschließlich 1,00 mm liegt.

6. Anzeigevorrichtung (100, 300, 500, 600, 700) nach Anspruch 1, wobei eine Dicke der Luftschicht (21) im Bereich von einschließlich 0,1 mm bis einschließlich 0,5 mm liegt.

7. Anzeigevorrichtung (100, 300, 500, 600, 700) nach Anspruch 1, wobei das Wärmeübertragungsblatt (18) sich nicht mit der Position der Platine (17 a, 17 b, 17 c) überlappt.

## Revendications

1. Dispositif d'affichage (100, 300, 500, 600, 700) comprenant:
un panneau d'affichage (12) montrant vers un observateur qui se trouve sur un sol sur la face avant du dispositif d'affichage (100, 300, 500, 600, 700);
dans lequel le dispositif d'affichage est configuré pour être positionné d'une manière telle que le panneau d'affichage est disposé dans une position verticale de sorte que, dans la perspective de l'observateur, le dispositif comprend une partie supérieure la plus éloignée du sol et une partie inférieure la plus proche du sol;
une pluralité d'unités de rétroéclairage (15a, 15b, 15c, 15d) disposées sur une face arrière du panneau d'affichage (12);
un premier cadre (16) fait de métal qui est disposé sur une face arrière de la pluralité des unités de rétroéclairage (15a, 15b, 15c, 15d);
un deuxième cadre (19) fait de métal qui est disposé sur une face arrière du premier cadre (16);
une feuille de transfert de chaleur (18) disposée entre le premier cadre (16) et le deuxième cadre (19) et formant une liaison directe avec les premier et deuxième cadres; dans lequel ladite feuille de transfert de chaleur (18) est positionnée sur la partie supérieure du dispositif d'affichage;
une carte (17a, 17b, 17c) disposée sur la face arrière du deuxième cadre (19) et comprenant un composant électronique, dans lequel ladite carte (17a, 17b, 17c) est positionnée sur la partie inférieure du dispositif d'affichage,
dans lequel une couche d'air (21) est formée entre le premier cadre (16) et le deuxième cadre (19) et est positionnée sur la partie inférieure du dispositif d'affichage dans le plan de la feuille de transfert de chaleur (18) et est en chevauchement avec le position de la carte (17a, 17b, 17c).

2. Dispositif d'affichage (100, 300, 500, 600, 700) selon la revendication 1, dans lequel, par rapport à l'observateur, la feuille de transfert de chaleur (18) est positionnée dans la moitié supérieure du panneau d'affichage (12), et la carte (17a, 17b, 17c) est positionnée dans la moitié inférieure du panneau d'affichage (12).

3. Dispositif d'affichage (100, 300, 500, 600, 700) selon la revendication 1, dans lequel une épaisseur de la feuille de transfert de chaleur (18) est comprise entre 0,01 mm inclus et 1,00 mm inclus.

4. Dispositif d'affichage (100, 300, 500, 600, 700) selon la revendication 1, dans lequel une épaisseur de la feuille de transfert de chaleur (18) est comprise entre 0,1 mm inclus et 0,5 mm inclus.

5. Dispositif d'affichage (100, 300, 500, 600, 700) selon la revendication 1, dans lequel une épaisseur de la couche d'air (21) est comprise entre 0,01 mm inclus et 1,00 mm inclus.

6. Dispositif d'affichage (100, 300, 500, 600, 700) selon la revendication 1, dans lequel une épaisseur de la couche d'air (21) est comprise entre 0,1 mm inclus et 0,5 mm inclus.

7. Dispositif d'affichage (100, 300, 500, 600, 700) selon la revendication 1, dans lequel la feuille de transfert de chaleur (18) n'est pas en chevauchement avec la position de la carte (17a, 17b, 17c).
